# EUROPÄISCHE PATENTSCHRIFT

(11) **EP 2 438 623 B1**
(45) Veröffentlichungstag und Bekanntmachung des Hinweises auf die Patenterteilung: **10.08.2016**
(21) Anmeldenummer: 10722323.2
(22) Anmeldetag: 01.06.2010
(51) Int. Cl.: H01L 31/048, H01L 31/05

(54) **PHOTOVOLTAISCHES MODUL MIT FLÄCHIGEM ZELLVERBINDER**
PHOTOVOLTAIC MODULE HAVING A PLANAR CELL CONNECTOR
MODULE PHOTOVOLTAÏQUE POURVU D'UN CONNECTEUR DE CELLULES PLAN

(30) Priorität: 04.06.2009 DE 102009023901
(43) Veröffentlichungstag der Anmeldung: 11.04.2012
(73) Patentinhaber: Fraunhofer-Gesellschaft zur Förderung der angewandten Forschung e.V., 80686 München (DE)
(72) Erfinder: WIRTH, Harry, 79249 Merzhausen (DE); WAGNER, Hans-Ulrich, 24598 Boostedt (DE); KALMBACH, Jens, 72285 Pfalzgrafenweiler (DE); HIRZLER, Bernd, 79346 Endingen (DE); STREBEL, Beat, CH-4118 Rodersdorf (CH)
(74) Vertreter: Pfenning, Meinig & Partner mbB
(86) Internationale Anmeldenummer: PCT/EP2010/003320
(87) Internationale Veröffentlichungsnummer: WO 2010/139454

(56) Entgegenhaltungen:
- WO-A1-2007/071064
- US-A- 5 951 786
- US-A1- 2009 065 043

## Beschreibung

Die Erfindung betrifft ein photovoltaisches Modul, das aus mindestens zwei Solarzellen besteht, wobei diese zumindest bereichsweise durch einen flächigen Zellverbinder verbunden sind. Der Zellverbinder besteht aus mindestens einer porösen Trägerschicht und mindestens einer Leiterstruktur, die auf der von den Solarzellen abgewandten Seite der Trägerschicht angeordnet sind. Anwendungen finden die Systeme der flächen Zellverbinder bei der Herstellung von Waferbasierten Photovoltaikmodulen vor allem aus Rückkontakt-Zellen mit beliebiger Kontaktanordnung in der Fläche.

Solarzellen müssen elektrisch in Serie verbunden werden, um die Ströme und damit die ohmschen Leitungsverluste zu verringern. Bei Rückkontakt-Zellen besteht die Aufgabe darin, auf der Rückseite der Zelle befindliche Kontaktpunkte mit den gegenpoligen Kontaktpunkten einer Nachbarzelle über eine oder mehrere Leitungen zu verbinden. Dabei kann abschnittsweise eine elektrische Isolierung zwischen Leitung und Zelle notwendig sein, insbesondere bei Zellen, deren Kontaktpunkte nicht vollständig am Zellrand angeordnet sind.

Für eine effiziente Modulproduktion ist es vorteilhaft, die Verbindungsleitungen auf einem Trägermaterial in der gewünschten Anordnung vorzubereiten. Auf diesen flächigen Zellverbindern müssen die Zellen dann nur noch positioniert und kontaktiert werden, bspw. durch Löten oder Kleben.

Bei einem nachfolgenden Laminierprozess muss ein flüssig-viskoses Material zwischen die Zellen und die Deckschichten des Moduls eindringen. Mit seiner Aushärtung schafft es einen mechanischen Verbund der Modulkomponenten.

Die US 5,951,786 beschreibt zwei Varianten eines Zellverbinders. Beim ersten Verfahren befindet sich eine flache, strukturierte Leiterschicht auf der Rückseitenfolie des Moduls. Dieses Verfahren hat den Nachteil, dass übliche Löttemperaturen die Rückseitenfolie beschädigen können.

Beim zweiten Verfahren befindet sich eine flache, strukturierte Leiterschicht auf der den Solarzellen zugewandten Seite eines flachen Trägers. Öffnungen oder Poren im Träger erlauben das Durchdringen von Einkapselungsmaterial im Laminierprozess.

Nachteil dieser Ausführung ist die Gefahr von Kurzschlüssen für den Fall, dass die Leiter über solche Bereiche der Zelle geführt werden müssen, die eine entgegengesetzte Polarität aufweisen. Dieses Problem tritt gelegentlich bei Zellen auf, die ihre Kontakte am Rand angeordnet haben, und es tritt regelmäßig bei Zellen auf, deren Kontakte in der Zellfläche liegen.

Die DE 10 2005 053 363 beschreibt einen 3-schichtigen Zellverbinder, bei dem eine Isolationsschicht zwei Leiterschichten trennt. Nachteil dieser Ausführung ist die Notwendigkeit einer schrittweisen Applikation in Schindeltechnik. Es kann somit kein zusammenhängender Zellverbinder in den Dimensionen des PV-Moduls in einem Schritt vorbereitet werden.

Die US 2009/006543 A1 beschreibt eine Solarzellenanordnung bei der die Solarzellen über Zellverbinder, die als gedruckter Schaltkreis (105) auf einem Film (103) aufgebracht ist, verbunden sind. Die eigentliche Kontaktierung mit den jeweiligen Solarzellen erfolgt über im Film (103) angeordnete Löcher (104), wobei das Material des gedruckten Schaltkreises (105) durch diese Löcher eingefügt wird. Hier ist nachteilig dass der Film keine Durchlässigkeit bzw. Aufnahmefähigkeit für ein verkapselndes Medium aufweist, sodass der eigentliche Zellverbinder nur punktuell mit der Solarzelle verbunden ist.

Ausgehend hiervon war es Aufgabe der vorliegenden Erfindung, photovoltaische Module bereitzustellen, deren Herstellung einfach zu handhaben ist und so eine effiziente Modulherstellung ermöglichen.

Diese Aufgabe wird durch das photovoltaische Modul mit den Merkmalen des Anspruchs 1 gelöst. Die weiteren abhängigen Ansprüche zeigen vorteilhafte Weiterbildungen auf.

Erfindungsgemäß wird ein photovoltaisches Modul bereitgestellt, das aus mindestens zwei Solarzellen besteht, die zumindest bereichsweise durch einen flächigen Zellverbinder verbunden sind, wobei der Zellverbinder mindestens eine poröse Trägerschicht und mindestens eine auf der von den Solarzellen abgewandten Seite der Trägerschicht angeordnete Leiterstruktur aufweist.

Kern der vorliegenden Erfindung ist somit, einen flächige Zellverbinder, der sich mit Materialkosten realisieren lässt, die nur geringfügig über den Kosten des Leitermaterials liegen. Der beschriebene flächige Zellverbinder ermöglicht eine schnelle Montage der matrixartig angeordneten Solarzellen in der Modulproduktion. Gleichzeitig lässt sich für Flächenkontakt-Zellen, etwa nach MWT-Technologie (engl. Metal Wrap Through), eine Zellverbindung mit besonders geringen Serienwiderstandsverlusten im Bereich von 0,5 bis 1,5 % realisieren.

Dabei wird unter einer porösen Trägerschicht erfindungsgemäß eine Schicht verstanden, die ungerichtete Poren aufweist. Diese besitzt somit im Mittel eine gleichmäßige Durchlässigkeit, beispielsweise für Gase und Flüssig-Viskose Medien. Eine perforierte Schicht, die räumlich gerichtete Kanäle bzw. Poren aufweist, ist folglich nicht mit der erfindungsgemäßen porösen Trägerschicht gleichzusetzen.

Vorzugsweise weist die poröse Trägerschicht Aussparungen auf, in denen die Leiterstruktur derart verläuft, dass die Leiterstruktur mit den Solarzellen elektrisch kontaktiert ist. Insbesondere ist die Leiterstruktur im Bereich der Aussparungen der Trägerschicht in Richtung der Solarzellen verformt. Derartige Verformungen sind Sicken oder Stufen. Die Höhe der Sicke oder Stufe entspricht dabei im Wesentlichen der Dicke der Trägerschicht.

In einer weiteren bevorzugten Variante weist die Leiterstruktur im Bereich der Aussparungen der Trägerschicht mindestens ein Entspannungselement auf. Das Entspannungselement bewirkt hierbei eine Verringerung der Spannungen in der Leiterstruktur und zwischen der Leiterstruktur und der Solarzelle an den Kontaktstellen. Als Entspannungselemente sind Sicken, Bögen oder andere indirekte Verbindungswege bevorzugt. Zur Entspannung im Bereich der Kontaktstellen können auch Strukturen in den Leiter eingebracht werden, die eine stärkere lokale Verzahnung mit dem Einkapselungsmaterial bewirken.

Die Leiterstruktur ist bevorzugt ein Draht, insbesondere ein Flach- oder Runddraht, kann aber auch als Stanzteil ausgeführt sein. Eine andere Möglichkeit für die Herstellung der Leiterstruktur besteht im Ätzen der Struktur direkt auf der Trägerschicht.

Die Leiterstruktur besteht vorzugsweise aus einem elektrisch leitfähigen Kern, insbesondere aus Kupfer, sowie einer Ummantelung aus einem Lotmaterial. Als Lotmaterial kommen Zinn, Silber oder Legierungen hiervon in Frage. Der elektrisch leitfähige Kern besteht bevorzugt aus einem Metall, insbesondere Kupfer oder Aluminium. Es ist ebenso möglich, andere Metalle oder leitfähig dotierte, nicht-metallische Werkstoffe, insbesondere Polymerwerkstoffe, einzusetzen. Vorzugsweise ist die mindestens eine Leiterstruktur im Bereich der Aussparung der Trägerschicht stoffschlüssig, insbesondere durch Kleben, Löten, Bonden oder Schweißen, oder kraftschlüssig, insbesondere durch Heften oder Weben, oder formschlüssig, insbesondere durch Prägen, mit der mindestens einen Trägerschicht verbunden.

Vorzugsweise verlaufen die Drähte im Wesentlichen parallel zu den Kanten der Solarzellen, wobei die Drähte pro Solarzelle mindestens eine Unterbrechung mit mindestens zwei Kontaktstellen zur Solarzelle aufweisen. Es ist dabei bevorzugt, dass die Drähte in 2 bis 6 Gruppen, insbesondere in 2 bis 3 Gruppen angeordnet sind.

Die mindestens eine Trägerschicht besteht vorzugsweise aus einem offenporigen Vlies oder Gewebe. Besonders bevorzugt sind dimensionsstabile Vliese aus gebundenen Fasern aus Glas oder einem Polymerwerkstoff.

Die Fasern sind vorzugsweise mittels eines Bindemittels fixiert. Hier ist es nicht erforderlich, dass die Fasern verwoben sind (sog. Non-Wovens).

Eine weitere bevorzugte Ausführungsform sieht vor, dass die Trägerschicht eine Haftschicht zur Fixierung der mindestens einen Leiterstruktur aufweist. Eine bevorzugte Ausführungsform der porösen Trägerschicht ist dabei ein Glasfaservlies, bestehend aus nichtverwebten (non-woven) Glasfasern mit einer haftfähigen Beschichtung.

Die Aussparungen in der Trägerschicht lassen sich durch Stanzen, Schneiden oder Bohren erzeugen.

Es ist weiterhin bevorzugt, dass das photovoltaische Modul mindestens eine erste Deckschicht auf der dem Lichteinfall zugewandten Seite des photovoltaischen Moduls aufweist, die im Wesentlichen transparente Eigenschaften besitzt. Die im Wesentlichen transparenten Eigenschaften betreffen hier den Wellenlängenbereich, der zur Umwandlung in elektrische Energie durch Solarzellen realisierbar ist.

Ebenso ist bevorzugt, dass das photovoltaische Modul mindestens eine zweite Deckschicht auf der dem Lichteinfall abgewandten Seite des photovoltaischen Moduls aufweist.

Weiterhin kann zwischen den Deckschichten und den Solarzellen und/oder der mindestens einen Trägerschicht ein Einkapselungsmaterial eingefüllt sein.

Die erfindungsgemäße Lösung basiert somit auf einem flächigen Zellverbinder, bei dem die Leiterschicht auf der den Solarzellen abgewandten Seite einer porösen Trägerschicht angeordnet ist. Die Trägerschicht und das beim Laminierprozess durchdringende Einkapselungsmaterial schafft damit eine isolierende Schicht zwischen Leiterabschnitten und Zellabschnitten mit entgegengesetzter Polarität. An den Kontaktstellen werden Aussparungen im Träger vorgesehen, so dass dort eine Verbindung zwischen Leiterstruktur und Solarzelle erfolgen kann. Hierzu wechselt die Leiterstruktur von der zellabgewandten zur zellzugewandten Seite der Trägerschicht. Die elektrische und mechanische Verbindung kann durch Löten, Kleben, Schweißen, Bonden oder andere bekannte Fügetechnologien erfolgen. Ebenso sind aber auch kraftschlüssige Verbindungen, insbesondere durch Heften oder Weben, oder formschlüssigge Verbindungen, insbesondere durch Prägen, möglich.

Die Leiterstruktur weist Aussparungen oder freie Flächen auf, durch die ein flüssig-viskoses Einkapselungsmaterial dringen kann. Das Material dringt weiter durch die Trägerschicht und schafft schließlich eine Verbindung zwischen der hinteren Deckschicht des Moduls und den Solarzellrückseiten.

Anhand der nachfolgenden Figuren soll der erfindungsgemäße Gegenstand näher erläutert werden, ohne diesen auf die hier gezeigten speziellen Ausführungsformen einschränken zu wollen.
- Fig. 1: zeigt eine erste erfindungsgemäße Ausführungsform im Querschnitt.
- Fig. 2: zeigt eine erfindungsgemäße Ausführungsform in der Draufsicht.
- Fig. 3: zeigt eine weitere erfindungsgemäße Ausführungsform in der Draufsicht.
- Fig. 4: zeigt eine erfindungsgemäße Ausführungsform im Querschnitt.
- Fig. 5: zeigt eine Ausführungsform des erfindungsgemäßen Zellverbinders.
- Fig. 6: zeigt eine weitere erfindungsgemäße Ausführungsform in der Draufsicht.
- Fig. 7: zeigt eine weitere erfindungsgemäße Ausführungsform in der Draufsicht.
- Fig. 8: zeigt eine weitere erfindungsgemäße Ausführungsform in der Draufsicht.

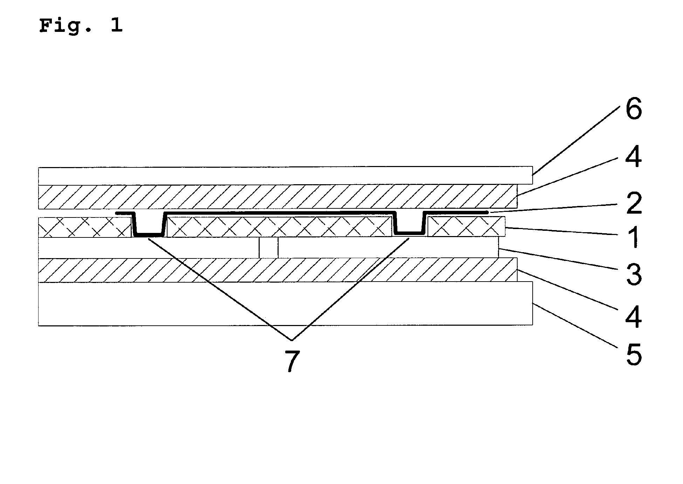

Fig. 1 zeigt eine bevorzugte Ausführung im Querschnitt mit Träger 1, Leiter 2, Zellen 3, Einkapselungsmaterial 4, vordere Deckschicht 5, hintere Deckschicht 6, Kontaktstellen 7. An den Kontaktstellen sind im Träger 1 Aussparungen und im Leiter 2 Sicken vorgesehen. Beim Laminierprozess dringt die Einkapselungsschicht 4 teilweise in den Träger 1 ein.

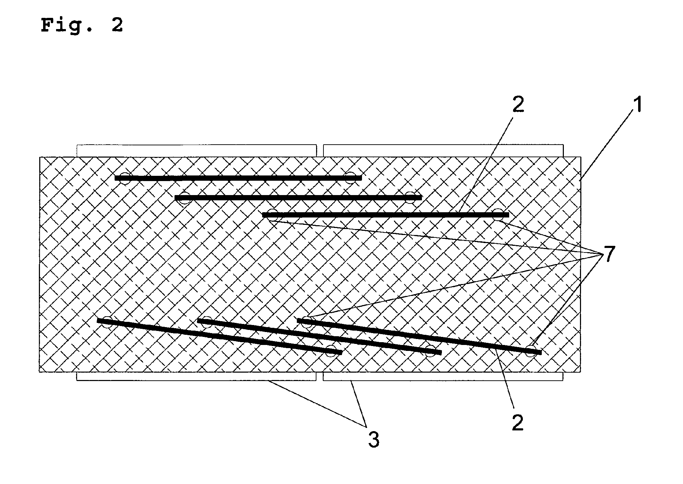

Fig. 2 zeigt eine bevorzugte Ausführung in der Aufsicht. Die Leiter 2, sind als Flachdrähte ausgeführt. Der Träger 1 weist an den Kontaktstellen 7 Löcher auf. Die Leiter können in beliebiger Anordnung zur Zellkante liegen, in der Abbildung sind sie parallel (oben) oder schräg (unten) zur Kante der Zelle 3 angeordnet.

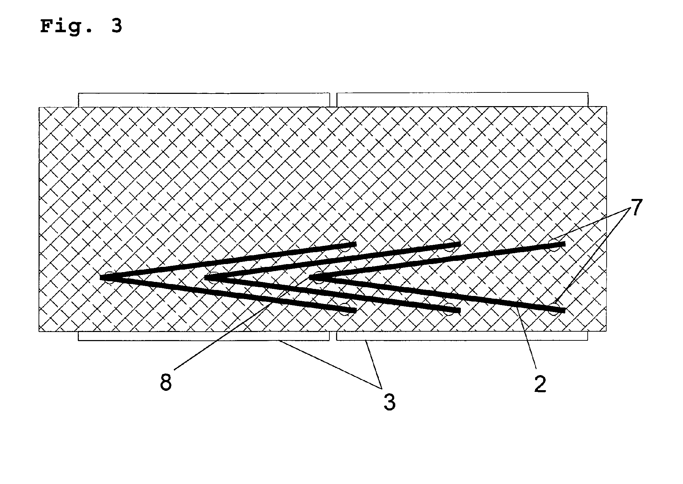

Fig. 3 zeigt eine Ausführung als gefalteter Flachdraht, der drei Punkte auf zwei Zellen verbindet. An der Stelle 8 wurde der Flachdraht gefaltet.

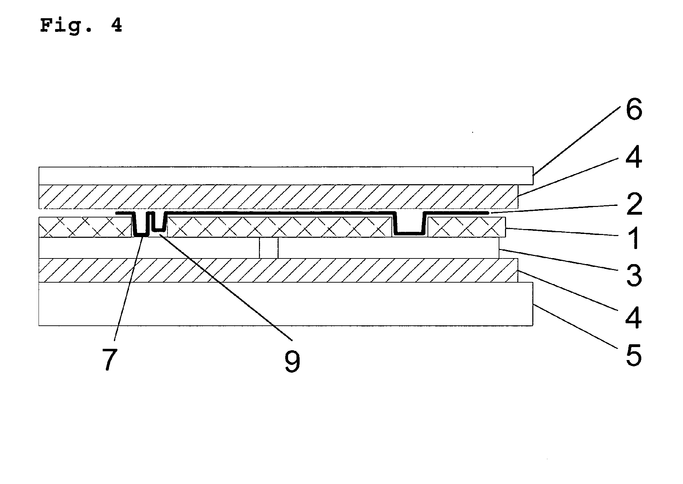

Fig. 4 zeigt eine Ausführung, bei der neben der Kontaktstelle 7 eine zusätzliche Sicke 9 zur Zugentlastung der Kontaktstelle vorgesehen wird.

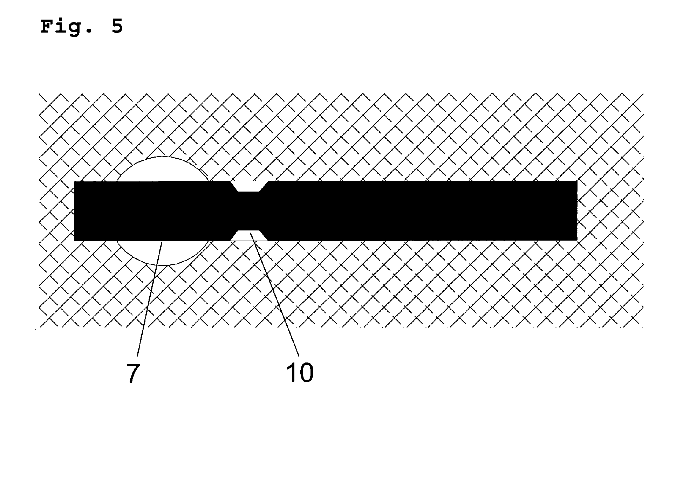

Fig. 5 zeigt einen Flachleiter in der Aufsicht, der eine Taillierung 10 in der Nähe der Kontaktstelle 7 aufweist. In Verbindung mit dem umgebenden Einkapselungsmaterial wird eine Zugentlastung der Kontaktstelle erreicht.

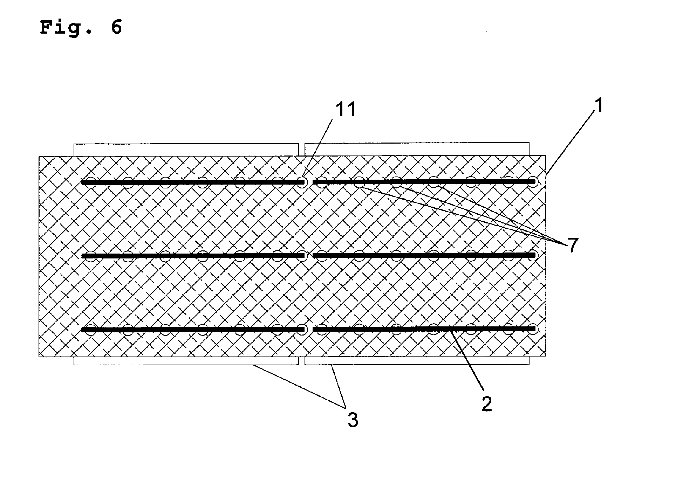

Der erfindungsgemäße flächige Zellverbinder kann auch für konventionelle Solarzellen (mit beidseitiger Kontaktanordnung) Anwendung finden. Fig. 6 zeigt eine Ausführung, bei der an den Stellen 7 Kontakte zwischen Zellverbinder und Zelle besteht. An den Stellen 11 im Zellzwischenraum werden vorderseitige und rückseitige Zellverbinder verbunden.

Bei der bevorzugten Ausführung des Trägers als Glasfaser-Vlies ist auch ein Einsatz des flächigen Zellverbinders zwischen der ersten Deckschicht und der Zellmatrix möglich. Wegen der ähnlichen Brechungsindizes von Vlies und Einkapselungsmaterial kommt es nicht zu bedeutenden Verlusten in der optischen Effizienz.

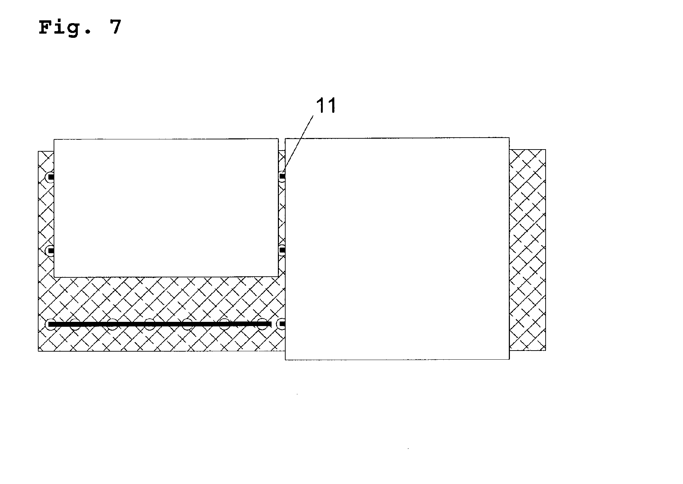

Fig. 7 zeigt die zu Fig. 6 korrespondierende Anordnung eines zweiten flächigen Zellverbinders vor den Zellen mit den Verbindungspunkten 11 zu dem rückseitigen flächigen Zellverbinder der Fig. 6. Die linke Solarzelle ist zur besseren Übersicht verkürzt dargestellt.

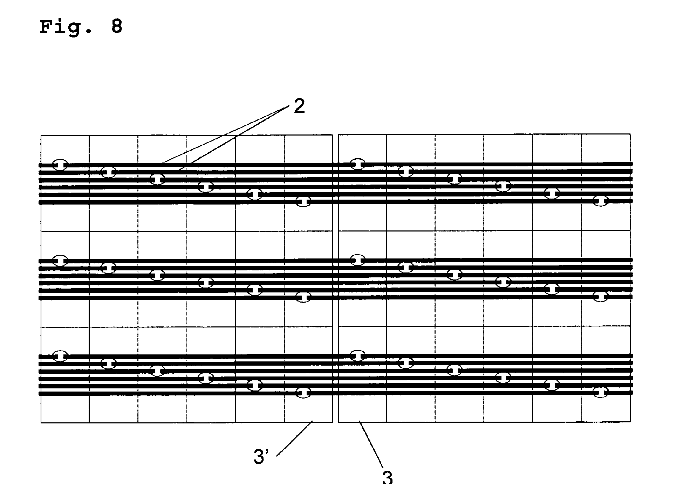

Fig. 8 zeigt eine Ausführungsform mit Verbindern 2, die parallel zu den Kanten der Solarzellen 3, 3' verlaufen. Einer einzigen Solarzelle 3 sind im vorliegenden Fall 18 Verbinder 2 zugeordnet, die in 3 Gruppen angeordnet sind. Die Enden der Verbinder 2 kontaktieren jeweils den Emitter einer Solarzelle 3 und die Basis der benachbarten Solarzelle 3' durch ovale Löcher in der Trägerschicht. Die Trägerschicht ist in Fig. 8 nicht dargestellt.

## Patentansprüche

1. Photovoltaisches Modul bestehend aus mindestens zwei Solarzellen, die zumindest bereichsweise durch einen flächigen Zellverbinder verbunden sind, wobei der Zellverbinder mindestens eine poröse Trägerschicht und mindestens eine auf der von den Solarzellen abgewandten Seite der Trägerschicht angeordnete Leiterstruktur aufweist.

2. Photovoltaisches Modul nach Anspruch 1,
**dadurch gekennzeichnet, dass** die poröse Trägerschicht Aussparungen aufweist, in denen die Leiterstruktur derart verläuft, dass die Leiterstruktur mit den Solarzellen elektrisch kontaktiert ist.

3. Photovoltaisches Modul nach dem vorhergehenden Anspruch,
**dadurch gekennzeichnet, dass** die Leiterstruktur im Bereich der Aussparungen der Trägerschicht in Richtung der Solarzellen, insbesondere in Form einer Sicke oder einer Stufe, verformt ist.

4. Photovoltaisches Modul nach dem vorhergehenden Anspruch,
**dadurch gekennzeichnet, dass** die Höhe der Sicke oder Stufe im Wesentlichen der Dicke der Trägerschicht entspricht.

5. Photovoltaisches Modul nach einem der vorhergehenden Ansprüche,
**dadurch gekennzeichnet, dass** die Leiterstruktur im Bereich der Aussparungen der Trägerschicht mindestens ein Entspannungselement, insbesondere in Form einer Sicke oder eines Bogens, aufweist.

6. Photovoltaisches Modul nach einem der vorhergehenden Ansprüche,
**dadurch gekennzeichnet, dass** die mindestens eine Leiterstruktur ein Draht, insbesondere ein Flach- oder Runddraht, oder eine auf der Trägerschicht gestanzte oder geätzte Struktur ist.

7. Photovoltaisches Modul nach dem vorhergehenden Anspruch,
**dadurch gekennzeichnet, dass** der Draht einen elektrisch leitfähigen Kern, insbesondere aus Kupfer, und eine Ummantelung aus einem Lotmaterial, insbesondere aus Zinn, Silber oder Legierungen hiervon aufweist.

8. Photovoltaisches Modul nach dem vorhergehenden Anspruch,
**dadurch gekennzeichnet, dass** der Kern aus einem Metall, insbesondere Kupfer oder Aluminium, oder einem leitfähig dotierten, nichtmetallischen Werkstoff, insbesondere einem Polymerwerkstoff besteht.

9. Photovoltaisches Modul nach einem der vorhergehenden Ansprüche,
**dadurch gekennzeichnet, dass** die mindestens eine Leiterstruktur im Bereich der Aussparung der Trägerschicht stoffschlüssig, insbesondere durch Kleben, Löten, Bonden oder Schweißen, oder kraftschlüssig, insbesondere durch Heften oder Weben, oder formschlüssig, insbesondere durch Prägen, mit der mindestens einen Trägerschicht verbunden ist.

10. Photovoltaisches Modul nach einem der vorhergehenden Ansprüche,
**dadurch gekennzeichnet, dass** die mindestens eine Trägerschicht aus einem offenporigen Vlies oder Gewebe besteht oder dieses im Wesentlichen enthält.

11. Photovoltaisches Modul nach einem der vorhergehenden Ansprüche,
**dadurch gekennzeichnet, dass** die mindestens eine Trägerschicht aus einem faserförmigen Material, insbesondere aus Glas oder Polymerwerkstoffen, besteht oder dieses im Wesentlichen enthält.

12. Photovoltaisches Modul nach dem vorhergehenden Anspruch,
**dadurch gekennzeichnet, dass** das faserförmige Material nicht verwebt ist, sondern durch mindestens ein Bindemittel fixiert ist.

13. Photovoltaisches Modul nach einem der vorhergehenden Ansprüche,
**dadurch gekennzeichnet, dass** das photovoltaische Modul mindestens eine erste Deckschicht auf der dem Lichteinfall zugewandten Seite des photovoltaischen Moduls aufweist, die im Wesentlichen transparente Eigenschaften besitzt.

14. Photovoltaisches Modul nach einem der vorhergehenden Ansprüche,
**dadurch gekennzeichnet, dass** das photovoltaische Modul mindestens eine zweite Deckschicht auf der dem Lichteinfall abgewandten Seite des photovoltaischen Moduls aufweist.

15. Photovoltaisches Modul nach einem der Ansprüche 13 oder 14,
**dadurch gekennzeichnet, dass** zwischen den Deckschichten und den Solarzellen und/oder der mindestens einen Trägerschicht ein Einkapselungsmaterial angeordnet ist.

## Claims

1. Photovoltaic module consisting of at least two solar cells which are connected at least in regions by a flat cell connector, wherein the cell connector has at least one porous carrier layer and at least one conductor structure arranged on the side of the carrier layer which is facing away from the solar cells.

2. Photovoltaic module according to claim 1, **characterised in that** the porous carrier layer has recesses in which the conductor structure runs in such a way that the conductor structure is electrically contacted with the solar cells.

3. Photovoltaic module according to the preceding claim, **characterised in that** the conductor structure is deformed in the region of the recesses of the carrier layer in the direction of the solar cells, in particular in the shape of a bead or a step.

4. Photovoltaic module according to the preceding claim, **characterised in that** the height of the bead or step substantially corresponds to the thickness of the carrier layer.

5. Photovoltaic module according to one of the preceding claims, **characterised in that** the conductor structure has at least one expansion element in the region of the recesses of the carrier layer, in particular in the shape of a bead or an arc.

6. Photovoltaic module according to one of the preceding claims, **characterised in that** the at least one conductor structure is a wire, in particular a flat or round wire, or a structure which is punched or etched on the carrier layer.

7. Photovoltaic module according to the preceding claim, **characterised in that** the wire has an electrically conductive core, in particular made from copper, and a casing made from a soldering material, in particular from tin, silver or alloys thereof.

8. Photovoltaic module according to the preceding claim, **characterised in that** the core consists of a metal, in particular copper or aluminium, or a conductively doped, non-metallic material, in particular a polymer material.

9. Photovoltaic module according to one of the preceding claims, **characterised in that** the at least one conductor structure is connected to the at least one carrier layer in the region of the recess of the carrier layer in a firmly bonded manner, in particular by adhesive bonding, soldering, bonding or welding, or in a non-positive manner, in particular by tacking or weaving, or in a positive manner, in particular by stamping.

10. Photovoltaic module according to one of the preceding claims, **characterised in that** the at least one carrier layer consists of an open-pored non-woven or woven fabric or substantially contains this.

11. Photovoltaic module according to one of the preceding claims, **characterised in that** the at least one carrier layer consists of a fibrous material, in particular of glass or polymer materials, or substantially contains this.

12. Photovoltaic module according to the preceding claim, **characterised in that** the fibrous material is not woven, but rather is fixed by at least one binding agent.

13. Photovoltaic module according to one of the preceding claims, **characterised in that** the photovoltaic module has at least one first cover layer on the side of the photovoltaic module facing towards the incidence of light which has substantially transparent properties.

14. Photovoltaic module according to one of the preceding claims, **characterised in that** the photovoltaic module has at least one second cover layer on the side of the photovoltaic module facing away from the incidence of light.

15. Photovoltaic module according to one of claims 13 or 14, **characterised in that** an encapsulation material is arranged between the cover layers and the solar cells and/or the at least one carrier layer.

## Revendications

1. Module photovoltaïque constitué d'au moins deux cellules solaires qui sont reliées au moins partiellement par l'intermédiaire d'un connecteur de cellules plat, le connecteur de cellules comprenant au moins une couche de support poreuse et au moins une structure conductrice disposée sur le côté de la couche de support opposé aux cellules solaires.

2. Module photovoltaïque selon la revendication 1, **caractérisé en ce que** la couche de support poreuse présente des évidements dans lesquels la structure conductrice s'étend de façon à ce que la structure conductrice soit mise en contact électrique avec les cellules solaires.

3. Module photovoltaïque selon la revendication précédente, **caractérisé en ce que** la structure conductrice est déformée, au niveau des évidements de la couche de support en direction des cellules solaires, plus particulièrement sous la forme d'une moulure ou d'un épaulement.

4. Module photovoltaïque selon la revendication précédente, **caractérisé en ce que** la hauteur de la moulure ou de l'épaulement correspond globalement à l'épaisseur de la couche de support.

5. Module photovoltaïque selon l'une des revendications précédentes, **caractérisé en ce que** la structure conductrice présente, au niveau des évidements de la couche de support, au moins un élément de détente, plus particulièrement sous la forme d'une moulure ou d'un arc.

6. Module photovoltaïque selon l'une des revendications précédentes, **caractérisé en ce que** l'au moins une structure conductrice est un fil, plus particulièrement un fil plat ou un fil rond, ou une structure poinçonnée ou gravée sur la couche de support.

7. Module photovoltaïque selon la revendication précédente, **caractérisé en ce que** le fil comprend un noyau électro-conducteur, plus particulièrement constitué de cuivre, et un revêtement en matériau de brasage, plus particulièrement en zinc, argent ou en alliages de ceux-ci.

8. Module photovoltaïque selon la revendication précédente, **caractérisé en ce que** le noyau est constitué d'un métal, plus particulièrement de cuivre ou d'aluminium, ou d'un matériau non métallique dopé de manière conductrice, plus particulièrement un matériau polymère.

9. Module photovoltaïque selon la revendication précédente, **caractérisé en ce que** l'au moins une structure conductrice est reliée, au niveau de l'évidement de la couche de support, par liaison de matière, plus particulièrement par collage, brasage, liaison ou soudure, ou par friction, plus particulièrement par agrafage ou tissage, ou par complémentarité de forme, plus particulièrement par estampage, avec l'au moins une couche de support.

10. Module photovoltaïque selon l'une des revendications précédentes, **caractérisé en ce que** l'au moins une couche de support est constituée d'une toison ou d'un tissu à pores ouverts ou contient essentiellement celui-ci.

11. Module photovoltaïque selon l'une des revendications précédentes, **caractérisé en ce que** l'au moins une couche de support est constituée d'un matériau en forme de fibres, plus particulièrement de verre ou de matériaux polymères ou contient essentiellement celui-ci.

12. Module photovoltaïque selon la revendication précédente, **caractérisé en ce que** le matériau en forme de fibres n'est pas tissé mais est fixé par au moins un liant.

13. Module photovoltaïque selon l'une des revendications précédentes, **caractérisé en ce que** le module photovoltaïque comprend au moins une première couche de recouvrement sur le côté, orienté vers l'incidence de la lumière, du module photovoltaïque, qui présente essentiellement des propriétés transparentes.

14. Module photovoltaïque selon l'une des revendications précédentes, **caractérisé en ce que** le module photovoltaïque comprend au moins une deuxième couche de recouvrement sur le côté, opposé à l'incidence de la lumière, du module photovoltaïque.

15. Module photovoltaïque selon l'une des revendications 13 ou 14, **caractérisé en ce que**, entre les couches de recouvrement et les cellules solaires et/ou l'au moins une couche de support, se trouve un matériau d'encapsulation.
